# EUROPEAN PATENT APPLICATION

(11) **EP 1 096 625 A2**
(43) Date of publication of application: **02.05.2001**
(21) Application number: 00309093.3
(22) Date of filing: 16.10.2000
(51) Int. Cl.: H01S 5/00

(54) **A method to conserve the current state of a wavelength stabilized laser module for failure mode analysis on a returned product**

(30) Priority: 28.10.1999 US 428648
(71) Applicant: LUCENT TECHNOLOGIES INC., Murray Hill, New Jersey 07974-0636 (US)
(72) Inventor: Stayt, John W., Schnecksville, PA (US)
(74) Representative: Watts, Christopher Malcolm Kelway, Dr.

(57) **Abstract**

A system and method are provided for updating and storing values of operating conditions for a wavelength stabilized laser module for use in failure mode analysis. The system and method utilize the embedded microprocessor already on the laser module with added firmware and a storage device. The present invention provides a method for acquiring and storing these data values for use after a failed laser module is returned to the manufacturer.

## Description

### Field Of The Invention

The present invention relates generally to tunable lasers and other tunable optical signal sources and more particularly to a method and system to diagnose failed laser modules This method and system capitalize on the embedded microprocessor in a wavelength stabilized laser system to provide operating condition values for failure analysis.

### Description Of The Related Art

Etalon based wavelength stabilized laser sources are rapidly becoming preferred within the optics field. These systems use dense wavelength division multiplexing (DWDM) to carry more laser signals in a relatively small package. The etalon components are an addition to conventional laser modules and provide the necessary functionality for DWDM

These systems typically have a life of 25 years. Over the 25 year life of such systems, there exists the possibility of failure of the laser module. While the failure rate for etalon based wavelength stabilized lasers is predicted to be relatively low, some of the support components of the laser module may be prone to premature failure, resulting in an increased risk of laser module failure.

When a customer returns a wavelength stabilized laser module that has failed in the field, the manufacturer often wants to know the conditions the laser module was under at the time of failure. Such knowledge would allow the manufacturer to reconstruct the failure, possibly eliminating the failure in laser modules subsequently manufactured. Manufacturers rarely receive such data because customers often do not know the conditions of failure or are unwilling to share usage information for fear of divulging a competitive edge. Currently, there exists no method for providing data which would allow a manufacturer to know the state of the system before or at the time the laser module failed.

Thus, there exists a need for a method and apparatus to allow for reconstruction of the failure of a wavelength stabilized laser module to further improve the quality and life of these devices.

### Summary Of The Invention

The present invention provides an apparatus and method which capture and store the current state of a laser module at the time of failure thus allowing for a failure mode analysis (FMA) on a customer returned module.

Wavelength stabilized laser modules typically contain a microprocessor embedded on the microcontroller's integrated circuit substrate. The present invention uses this embedded microprocessor together with added firmware and a storage device to periodically save various operating parameters of the laser module. Examples of information to be periodically saved include laser bias current, modulator bias voltage, solid state amplifier bias current, distributed Bragg reflector (DBR) tuning value, requested channel number, recurrence of channel usage, back facet power, front facet power, etalon and reference signal levels, wavelength look-up table values, laser temperature, and control circuitry temperature. The term "channel" is an industry term having equivalent meaning to the term "wavelength." A wavelength look-up table is used to determine the necessary operating conditions, i.e., bias conditions and temperature, of a laser module to output the desired wavelength as predetermined by the end product system requirements. The values in the look-up table are defined during the calibration of the laser module.

In accordance with the invention, this data may be periodically updated on either a time basis and/or after a channel change request. A channel change request is a request to change wavelengths (signals). Furthermore, this invention supports intelligent updating, where only changed information is replaced in the storage device on each update. The stored data is retained, even after failure of the laser module.

With retention of the operating parameter data, a simulation may later be performed on a returned stabilized laser module to determine the exact conditions that lead to failure. This apparatus and method is a low cost solution that allows a way to duplicate actual field conditions and may be implemented in many current lasers and wavelength locker systems. (A wavelength locker system is a control system which maintains signal separation amongst various signals propagating along different wavelengths.)

These and other features and advantages of the invention will be more clearly understood from the following detailed description of the invention which is provided in connection with the accompanying drawings.

### Brief Description Of The Drawings

FIG. 1 illustrates an etalon based wavelength stabilized laser system with a storage device and firmware in accordance with a preferred embodiment of this invention;
FIG. 2 illustrates a block diagram of a method for updating operating parameter values stored in the memory of a storage device based upon a predetermined periodic time interval for the system of FIG. 1;
FIG. 3 illustrates a block diagram of a method for updating operating parameter values stored in the memory of a storage device after a channel change request for the system of FIG. 1; and
FIG. 4 illustrates a block diagram of a method for updating operating parameter values stored in the memory of a storage device using both time based periodic updates and updates after a channel change for the system of FIG. 1.

### Detailed Description Of Preferred Embodiments

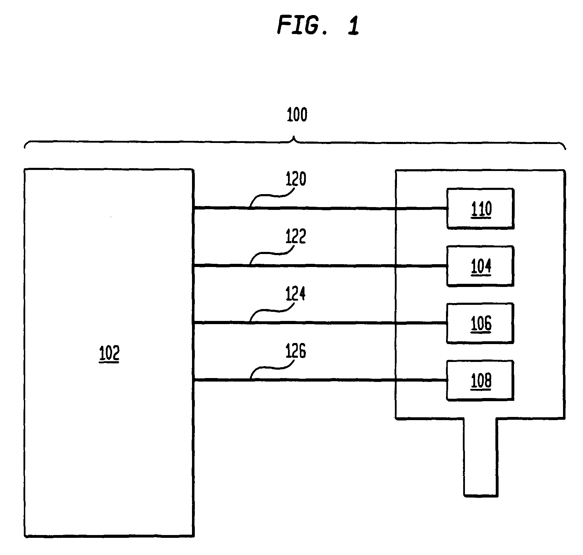

Referring now to the drawings, where like reference numerals designate like elements, there is shown in FIG. 1 an etalon based wavelength stabilization laser system 100. The laser system 100 includes a microprocessor 102, a storage device 104, firmware 106, an optical sub-assembly 108, and an etalon sub-assembly 110. Input/output control lines 120-126 provide communication between these components. The microprocessor 102 can be any microprocessor, microcontroller or controller commonly known in the art to control the optical sub-assembly 108 (which may include lasers, amplifiers, modulators and photo diodes). The storage device 104 can be any type of memory or memory system capable of retaining data in the absence of power, e.g., an electrically erasable programmable read only memory (EEPROM), flash memory, etc. The storage device 104 can also be a system comprising random access memory, static memory and a capacitor, where data is maintained in the random access memory and upon a power failure the data is written into the static memory with the reserve power held in the capacitor. The firmware 106 contains the routines which dictate the updating mechanism and may be embodied on read only memory. The etalon sub-assembly 110 assists the laser system 100 by determining which wavelength is being used. Other etalon components control the laser system 100 to maintain wavelength separation between signals. Thus, the etalon technology sub-assembly 110 is added functionality for wavelength stabilized laser systems which employ DWDM. As such, this invention may be practiced with a laser system which does or does not employ etalon technology.

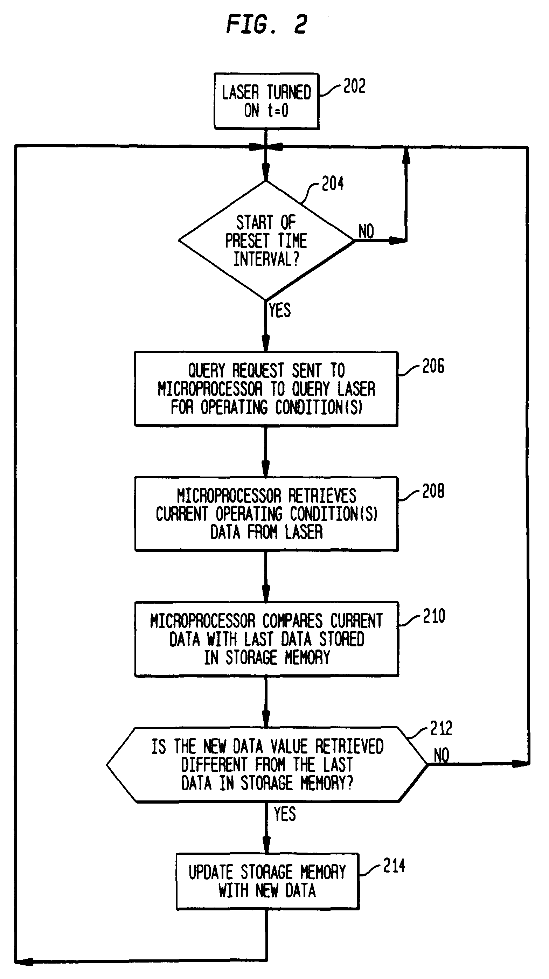

FIG. 2 illustrates in a flow chart format an updating method using time based updates. After the laser system 100 is turned on 202, where time = 0, the firmware 106, which includes time based logic, monitors for the beginning of a predetermined time interval 204. When a new time interval begins, in step 206, the firmware 106 requests that the embedded microprocessor 102 retrieve at least one data value regarding the laser system's 100 operating condition. The microprocessor 102, in compliance with the request, retrieves the data 208. In step 210, the microprocessor 102 checks for the stored value of the data of the same operating condition held in storage device 104. In step 212-214, if the storage device 104 has a different value then that retrieved from the laser system 100, then such data is updated in the storage device 104. Alternatively, steps 212-214 may be configured to update data in the storage device 104 only when the data value retrieved from the laser system 100 falls outside of a predefined value range for that particular operating condition. For example, steps 212-214 may be configured to only update data in storage device 104 if the laser bias current increases or decreases more than 0.2 amperes from its value stored in the storage device 104. If the microprocessor 102 retrieved a value which is the same as that in the storage device 104 or within a predetermined value range, the method is terminated to preserve efficiency and begins back at step 204.

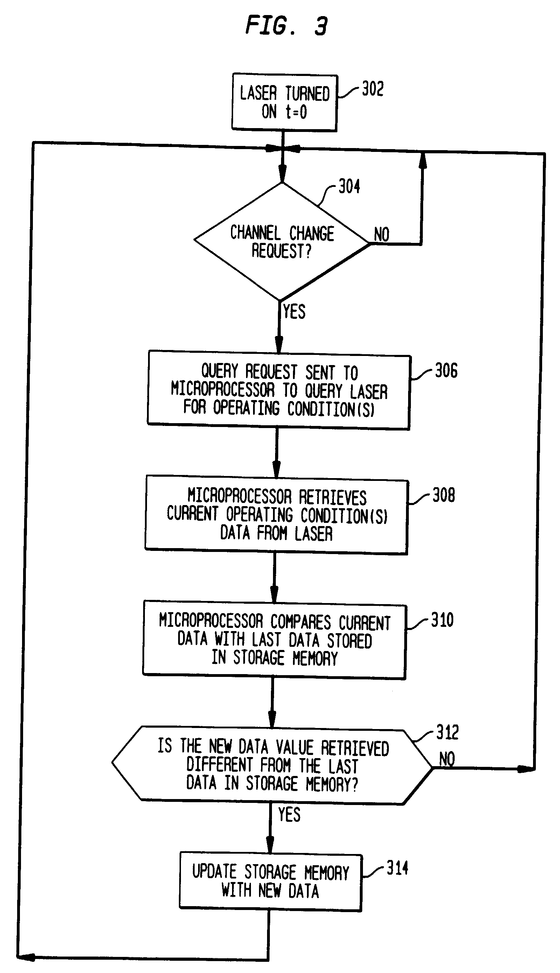

The method may also be initiated by having the microprocessor 102 query the laser system 100 after a channel change request 304 as depicted in FIG. 3. In such a scenario the same procedure is followed but the firmware 106 has a different initiation state 304. Initiating the query after a channel change is important because if a failure occurs right after a channel change an analyst would desire operating condition data relevant to the changed channel.

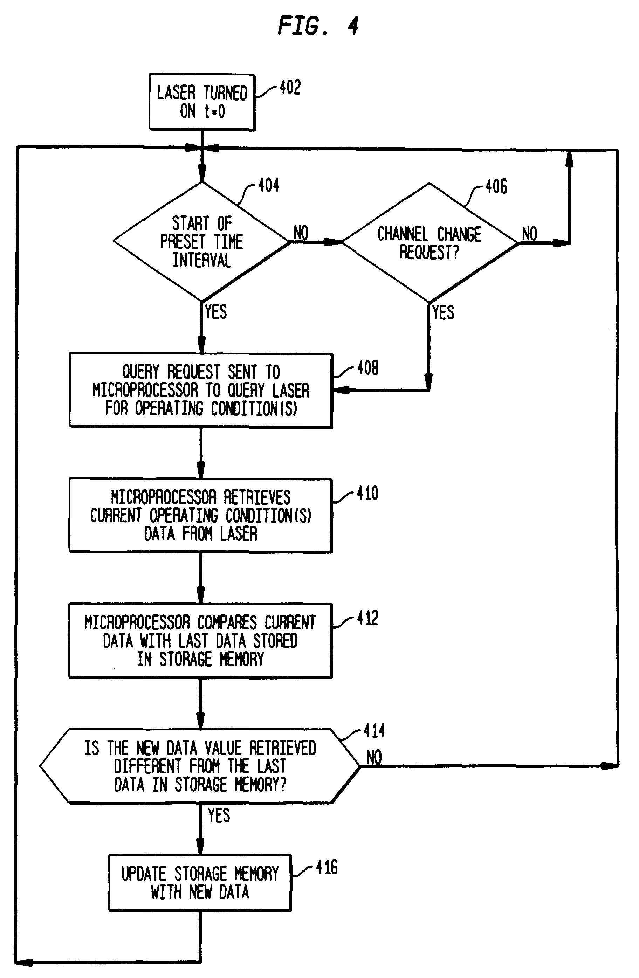

FIG. 4 illustrates the system of FIG. 1 where the firmware 106 initiates the query upon either the beginning of a time interval or channel change request. In step 404 the method checks it see if the time interval has reached a beginning point. If not, in step 406, the method further checks to see if a channel change request has just occurred. If either of those items in steps 404 or 406, yields a positive response then the microprocessor 102 is requested to query for the data values 408. In the event that neither condition in steps 404 or 406 are satisfied the routine continues to check for those conditions in the next clock cycle of the microprocessor 102. The remainder of the process is the same as in FIGS. 2 and 3.

According to another embodiment of the present invention, the storage device 104 maintains a back up copy of the data in the event of a read/write failure corrupting the original data. Coherency between the original data and backed up data in this embodiment may be maintained by the use of one or more coherency bits. For example, a coherency bit may be used to mark each data block in the original data as clean or dirty, e.g., "0" representing clean, "1" representing dirty. If a data block is changed in the original data, the data block is marked as dirty by the respective coherency bit, indicating to the system that the modified data block needs to be updated in the backed up data.

According to another embodiment of the present invention, the storage device 104 and firmware 106 can be both implemented on the same electrically erasable programmable read only memory (EEPROM) capable of storing dynamic and static data.

According to another embodiment of the present invention, the firmware 106 can be implemented using hardware logic gates.

While certain embodiments of the invention have been described and illustrated above, the invention is not limited to these specific embodiments as numerous modifications, changes and substitutions of equivalent elements can be made without departing from the spirit and scope of the invention. Accordingly, the scope of the present invention is not to be considered as limited by the specifics of the particular structures which have been described and illustrated, but is only limited by the scope of the appended claims.

## Claims

1. A laser operation monitoring system comprising:
a controller coupled to a laser system for periodically detecting the value of at least one operating parameter of said laser system; and
a storage device operable by said controller for storing a detected value of said at least one operating parameter, said storage device retaining said detected value upon a failure of said laser system.

2. The system of claim 1 further comprising firmware for storing instructions for said controller.

3. The system of claim 2, wherein said firmware comprises an electrically erasable programmable read-only memory.

4. The system of claim 2, wherein said firmware comprises read only memory.

5. The system of claim 1 further comprising at least one logic circuit for storing instructions for said controller.

6. The system of claim 1, wherein said laser system further comprises an etalon sub-assembly coupled to said controller.

7. The system of claim 1, wherein said storage device comprises electrically erasable programmable read-only memory.

8. The system of claim 1, wherein said storage device comprises a capacitor.

9. The system of claim 8, wherein said storage device further comprises static memory.

10. The system of claim 9, wherein said storage device further comprises random access memory.

11. The system of claim 1, wherein said operating parameters comprise laser bias current data.

12. The system of claim 1, wherein said operating parameters comprise modulator bias voltage data.

13. The system of claim 1, wherein said operating parameters comprise solid state amplifier current data.

14. The system of claim 1, wherein said operating parameters comprise the distributed Bragg reflector tuning value.

15. The system of claim 1, wherein said operating parameters comprise requested channel number data.

16. The system of claim 1, wherein said operating parameters comprise recurrence of channel usage data.

17. The system of claim 1, wherein said operating parameters comprise laser back facet power data.

18. The system of claim 1, wherein said operating parameters comprise laser front facet power data.

19. The system of claim 1, wherein said operating parameters comprise etalon signal level data.

20. The system of claim 1, wherein said operating parameters comprise reference signal level data.

21. The system of claim 1, wherein said operating parameters comprise the wavelength look-up table values.

22. The system of claim 1, wherein said operating parameters comprise laser temperature data.

23. The system of claim 1, wherein said operating parameters comprise etalon temperature data.

24. The system of claim 1, wherein said operating parameters comprise control circuitry temperature data.

25. A laser operation monitoring system comprising:
an optical sub-assembly;
a controller coupled to said optical sub-assembly; and
a storage device coupled to said controller for periodically storing values of at least one operating parameter of said optical sub-assembly prior to failure of said optical assembly.

26. The system of claim 25 further comprising an etalon sub-assembly.

27. The system of claim 25, wherein said controller comprises a microprocessor.

28. A method of archiving operating parameter data on a laser system, said method comprising:
initiating a query of a current data value of at least one operating parameter;
querying for said current data value of said at least one operating parameter; and
storing said current data value of said at least one operating parameter.

29. The method of claim 28, wherein said current data value of said at least one operating parameter is stored only if said current data value and the last data value stored for said at least one operating parameter are different.

30. The method of claim 28, wherein said current data value of said at least one operating parameter is stored only if said current data value is outside a predetermined value range from the last data value stored for said at least one operating parameter.

31. The method of claim 28, wherein said query is initiated on a predefined time interval.

32. The method of claim 28, wherein said laser system includes multiple channels and said query is initiated after a channel change request.

33. The method of claim 28 further comprising the step of maintaining a back up of said current data value.

34. The method of claim 33 further comprising the step of maintaining data coherency between said back up data and the original data by the use of a data coherency mechanism.

35. The method of claim 28, wherein said step of initiating a query is performed by firmware.

36. The method of claim 35 further comprising the step of said firmware requesting a controller to query said laser system for said current value of said at least one operating parameter.

37. The method of claim 28, wherein said query is performed by said controller.

38. The method of claim 28, wherein said current data value of said at least one operating parameter is stored in a storage device.

39. A method of archiving operating parameter data on a laser system, said method comprising:
initiating a query;
querying the laser system for the current data value of at least one operating parameter;
checking the previous data value stored for said at least one operating parameter; and
storing said current data value of said at least one operating parameter.

40. The method of claim 39, wherein said current data value of said at least one operating parameter is stored only if said previous data value and said current data value are different.

41. The method of claim 39, wherein said current data value of said at least one operating parameter is stored only if said current data value is outside of a predetermined value range from said previous data value for said at least one operating parameter.

42. The method of claim 39, wherein said query is initiated on a predefined time interval.

43. The method of claim 39, wherein said laser system includes multiple channels and said query is initiated after a channel change request.
